(19) **Europäisches Patentamt / European Patent Office / Office européen des brevets**

(11) **EP 2 766 927 B1**

(12) **FASCICULE DE BREVET EUROPEEN**

(45) Date de publication et mention
de la délivrance du brevet:
**13.01.2016 Bulletin 2016/02**

(21) Numéro de dépôt: **12767036.2**

(22) Date de dépôt: **06.09.2012**

(51) Int Cl.:
*H01L 23/498* (2006.01)    *H01L 21/60* (2006.01)
*H01L 23/13* (2006.01)

(86) Numéro de dépôt international:
**PCT/FR2012/051995**

(87) Numéro de publication internationale:
**WO 2013/054015 (18.04.2013 Gazette 2013/16)**

(54) **HYBRIDATION FLIP-CHIP DE COMPOSANTS MICROELECTRONIQUES AU MOYEN D'ELEMENTS DE CONNEXION RESISTIFS FUSIBLES SUSPENDUS**

FLIP-CHIP-HYBRIDISIERUNG VON MIKROELEKTRONISCHEN BAUTEILEN MIT SUSPENDIERTEN SCHMELZBAREN WIDERSTANDSVERBINDUNGSELEMENTEN

FLIP-CHIP HYBRIDIZATION OF MICROELECTRONIC COMPONENTS USING SUSPENDED FUSIBLE RESISTIVE CONNECTION ELEMENTS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **13.10.2011 FR 1159239**

(43) Date de publication de la demande:
**20.08.2014 Bulletin 2014/34**

(73) Titulaire: **Commissariat à l'Énergie Atomique et aux Énergies Alternatives**
**75015 Paris (FR)**

(72) Inventeur: **ALIANE, Abdelkader**
**F-38100 Grenoble (FR)**

(74) Mandataire: **Cabinet Laurent & Charras**
**Le Contemporain**
**50 Chemin de la Bruyère**
**69574 Dardilly Cedex (FR)**

(56) Documents cités:
**EP-A2- 1 193 750    US-A- 5 700 987**
**US-A- 5 951 893**

## Description

### DOMAINE DE L'INVENTION

L'invention a trait au domaine de l'assemblage de composants microélectroniques, et plus particulièrement à l'hybridation face-contre-face, ou hybridation « *flip-chip* ».

### ETAT DE LA TECHNIQUE

L'assemblage par la technique dite de *« flip chip »* consiste usuellement à former des billes électriquement conductrices sur une face d'un premier composant électronique et à former des éléments de connexion électriquement conducteurs, notamment des billes ou des plages de connexion, sur une face d'un second composant selon un motif de connexion prédéterminé. Le premier composant est alors reporté sur le second composant de manière à mettre en correspondance les billes avec les éléments de connexion, puis l'ensemble est pressé et chauffé. Les billes se déforment et fondent pour former des connexions électriques perpendiculaires au plan principal des composants électroniques, généralement sous la forme d'une tranche.

La technique la plus classique pour réaliser l'assemblage est de mettre en oeuvre un chauffage global de l'ensemble, par exemple en plaçant les deux composants sous une atmosphère contrôlée en température.

Le document US 5 700 987 par exemple divulgue un procédé de réalisation d'un dispositif hybridé.

Toutefois, la fusion d'une bille métallique nécessite de hautes températures, supérieures à 170 °C. Or, ces températures ne sont pas compatibles avec les composants organiques, notamment les composants en matière plastique tel que le PEN (polyéthylène naphtalate) et le PET (polyéthylène téréphtalate), qui présentent des températures de transition vitreuse inférieures, de 120 °C pour le PEN et de 70°C pour le PET par exemple. Ainsi en soumettant un composant plastique à la température de fusion des billes de soudure, le composant en plastique passe à un état caoutchouteux et se déforme fortement, voire se détruit.

### EXPOSE DE L'INVENTION

Le but de la présente invention est de proposer un procédé permettant une hybridation qui met en oeuvre un chauffage localisé des billes métalliques tout en isolant thermiquement de manière efficace le composant munis des éléments de connexion.

A cet effet, l'invention a pour objet un procédé de réalisation d'un dispositif hybridé consistant à réaliser un premier composant microélectronique muni sur une face de billes métalliques, et un second composant microélectronique muni sur une face d'éléments de connexion correspondant auxdites billes métalliques, et à hybrider les premier et second composants de manière à fixer les billes métalliques du premier composant aux éléments de connexion du second composant.

Selon l'invention :

- la fabrication du second composant microélectronique consiste :

    o à réaliser un substrat muni de cavités aux emplacements prévus pour les éléments de connexion; et
    ◦ à réaliser des éléments résistifs en métal fusible suspendus respectivement au dessus des cavités ;

- et l'hybridation des premier et second composants consiste :

    ◦ à reporter le premier composant sur le second composant de manière à faire reposer les billes métalliques sur les éléments résistifs suspendus ; et
    ◦ à appliquer un courant électrique au travers des éléments résistifs de manière à faire fondre ceux-ci.

En d'autres termes, le substrat est isolé de l'élément en fusion par de l'air jusqu'à ce que le métal en fusion s'écoule dans la cavité. Par ailleurs, la fusion des éléments résistifs entraine l'affaissement du premier composant sous son propre poids. Les billes métalliques se retrouvent donc introduites dans les cavités au contact du métal en fusion et adhèrent au substrat une fois le métal refroidi.

Selon un mode de réalisation, les éléments résistifs sont réalisés sous la forme de serpentins ou de tiges. Notamment, les éléments résistifs sont constitués de métal à bas point de fusion, par exemple en indium ou en alliage d'or et d'étain. Les éléments résistifs présentent donc une forte résistance électrique. Il est ainsi possible d'obtenir un échauffement élevé avec un courant faible et/ou très rapidement.

Selon un mode de réalisation, le substrat du second composant microélectronique comprend du plastique, notamment du PEN ou du PET. Par exemple, le substrat est un substrat flexible.

Selon un mode de réalisation, les éléments résistifs suspendus sont obtenus de la manière suivante :

- dépôt de deux plages métalliques autour de chaque cavité ;
- remplissage des cavités par de la résine ;
- réalisation des éléments résistifs sur la résine et sur les plages métalliques, en laissant au moins un passage d'accès à la résine ; et
- retrait de la résine des cavités par le au moins un passage d'accès.

Notamment, les plages métalliques de connexion ont une surface supérieure ou égale à deux fois la surface de la cavité.

Selon un mode de réalisation, le procédé comporte, avant la réalisation des éléments résistifs suspendus, le dépôt d'une couche de métal dans le fond de chaque cavité et d'au moins une connexion électrique au contact de ladite couche. Une interconnexion mécanique et électrique des premier et second composants est ainsi obtenue.

Selon un mode de réalisation, la hauteur des cavités est supérieure ou égale à 1/8 de la hauteur des billes.

**BREVE DESCRIPTION DES FIGURES**

La présente invention sera mieux comprise à la lecture de la description qui va suivre, donnée uniquement à titre d'exemple, et réalisée en relation avec les dessins annexés, dans lesquels des références identiques désignent des éléments identiques ou analogues, et dans lesquels :

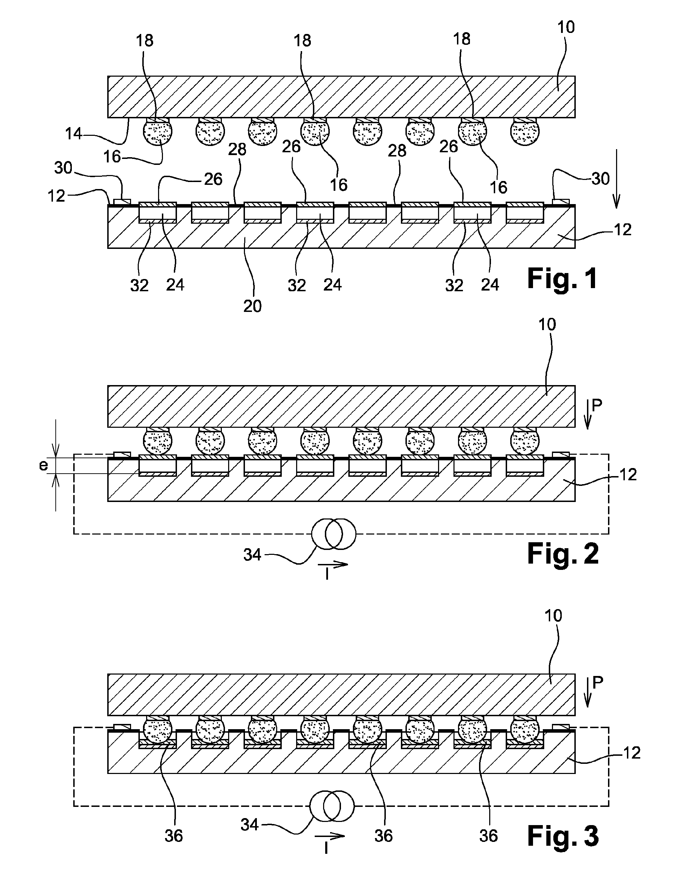

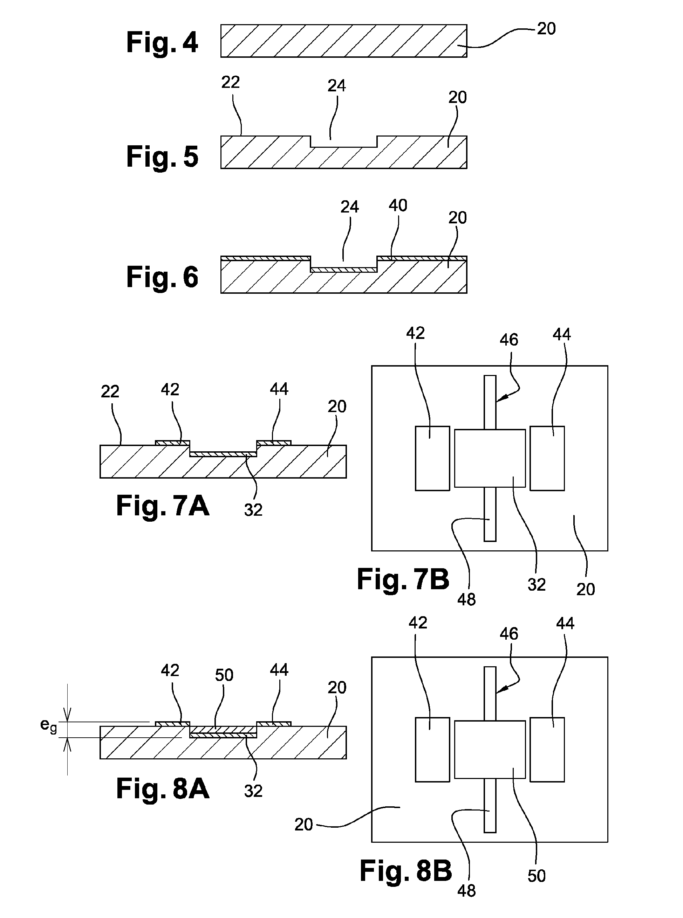

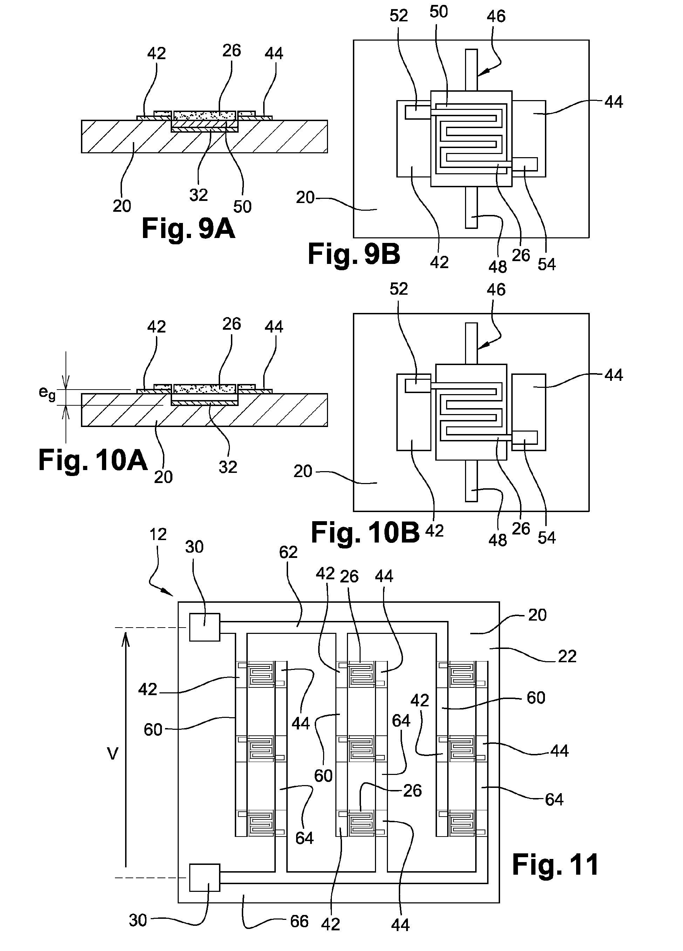

   ▪ les figures 1 à 3 sont des vues en coupe schématique illustrant un procédé d'hybridation d'un premier et d'un second composants microélectroniques selon l'invention ;
   ▪ les figures 4 à 10 sont des vues schématiques illustrant un procédé de fabrication d'un second composant selon l'invention muni d'éléments résistifs fusibles suspendus au dessus de cavités ; et
   ▪ la figure 11 est une vus schématique de dessus d'un second composant illustrant un schéma de connexion électrique des éléments résistifs fusibles.

**DESCRIPTION DETAILLEE DE L'INVENTION**

Un procédé d'hybridation d'un premier composant microélectronique **10** avec un second composant microélectronique **12** selon l'invention est à présent décrit en relation avec les figures schématiques en coupe 1 à 3.

Le premier microcomposant **10,** par exemple une puce microélectronique à base de silicium, comporte sur l'une de ses faces **14** des billes métalliques **16,** par exemple soudées à des plages métalliques **18,** comme cela est connu en soi de l'état de la technique.

Le second microcomposant **12** comprend un substrat **20,** par exemple un substrat flexible en plastique, constitué notamment de PET ou de PEN, dans une face **22** duquel sont réalisées des cavités **24** destinées à recevoir respectivement les billes **14** du premier composant **10.**

Un élément résistif **26** en matériau fusible, par exemple en indium ou en alliage d'or et d'étain, est par ailleurs suspendu au dessus de chaque cavité **24** et est connecté, par exemple via des pistes métalliques **28** réalisée sur la face **22** du second composant **12,** à des bornes d'alimentation électrique **30,** de manière à permettre le passage d'un courant électrique dans celui-ci.

De manière optionnelle, le fond de chaque cavité **24** comporte en outre une plage métallique **32** pour la connexion électrique de la bille **14** ultérieurement introduite dans celle-ci avec par exemple des circuits électroniques présents dans le substrat **12.**

Le procédé d'hybridation débute par le report du premier composant **10** sur le second composant **12** en alignant les billes **14** avec les éléments résistifs **26** (figure 1). Le premier composant **10** repose alors sur le second composant **12** en lui appliquant son poids *P* (figure 2).

Un courant électrique *I* est ensuite appliqué à chacun des éléments résistifs fusibles **26,** par exemple au moyen d'une source de tension ou de courant **34,** de manière à faire fondre ceux-ci par effet Joule. Le matériau en fusion s'écoule alors dans les cavités **24.** N'étant plus supporté par les éléments **26** qui ont été détruits par fusion pour former le contact mécanique et électrique, le premier composant **10** s'affaisse alors sous l'effet de son propre poids, et les billes **16** sont introduites dans les cavités avec le matériau en fusion **36** (figure 3). Le procédé se termine alors par le refroidissement du matériau en fusion **36** qui se solidifie en adhérant aux fonds des cavités **24** et aux billes **16,** de sorte qu'il est ainsi formé des connexions mécaniques et électriques entre les composants **10, 12.**

Ainsi, pendant toute la période de chauffage des éléments résistifs fusibles **26,** le substrat **20** est protégé d'un échauffement excessif par l'air remplissant les cavités **24** et n'entre en contact avec le matériau en fusion qu'au dernier moment, à savoir uniquement lorsque les éléments fusibles **26** sont détruits. En outre, le refroidissement des éléments fusibles débute immédiatement après leur destruction puisque cette destruction coupe le passage de courant, et par conséquent l'échauffement par effet Joule.

De préférence, la hauteur *e* des cavités **24** est comprise dans notre cas entre 2 et 8 $\mu$m D'une manière générale, la hauteur *e* des cavités est supérieure ou égale à 1/8 de la hauteur de la bille.

Il va à présent être décrit en relation avec les figures 4 à 11 un procédé de fabrication du second composant **12.**

Le procédé débute par la fabrication du substrat **20,** par exemple un substrat flexible en PET ou en PEN (figure en coupe 4) et se poursuit par la formation des cavités **24** dans une face **22** du substrat **20,** par exemple par l'application d'un plasma oxygène au travers d'un masque (figure en coupe 6).

Avantageusement, les parois des cavités **24** présentent une pente légèrement inclinée vers l'intérieur de manière à permettre de bloquer mécaniquement les billes 16 après le refroidissement.

Une couche de métal **40,** par exemple une couche d'or, est ensuite déposée pleine plaque sur le substrat **20,** par exemple par évaporation (figure en coupe 6). Notamment une couche de métal est déposée dans et autour de chaque cavité **24.**

La couche de métal **40** est alors gravée, par exemple au moyen d'une photolithographie et d'une étape de gravure humide ou plasma, de manière à définir, pour chaque cavité **24,** deux plages de connexion **42, 44** sur la face **22,** isolées électriquement du métal déposé dans la cavité **24,** ainsi que deux plages de connexion **46, 48** sur la face **22,** isolées électriquement des plages **42, 44** et en contact avec le métal **32** déposé dans la cavité **24** (figure en coupe 7A et figure de dessus 7B).

Le procédé se poursuit alors par le dépôt d'une résine **50** dans chaque cavité **22** de manière à protéger le métal **32** déposé dans les cavités **24** et définir une surface solide sur laquelle seront ultérieurement formés les éléments résistifs fusibles **26** (figure en coupe 8A et figure de dessus 8B). De manière avantageuse, la résine ne remplit pas entièrement les cavités **24** et est légèrement en retrait par rapport à la face **22** du substrat **20** pour permettre à l'élément résistif fusible de se courber vers le bas suivant son poids. Il est ensuite procédé à un nettoyage des plages de connexion **42, 44, 46, 48,** par exemple au moyen d'un plasma d'oxygène, de puissance comprise entre 30 W et 50 W, appliqué pendant une dizaine de secondes.

Les éléments résistifs fusibles **26** sont ensuite formés sur la résine **50,** au droit de chaque cavité **24,** par exemple au moyen d'une photolithographie déposant du métal fusible au travers d'un masque de forme souhaitée pour les éléments **26** (figure en coupe 9A et figure de dessus 9B). Chaque élément résistifs **26** se prolonge par ailleurs par deux plages métalliques **52, 54** déposées respectivement sur les plages de connexion **42** et **44.** Chaque élément **26** peut ainsi être alimenté en courant via les plages **42, 44.**

Avantageusement, les plages métalliques de connexion **42** et **44** ont une surface supérieure ou égale à deux fois la surface de la cavité **24** afin de favoriser une élévation de température sur les deux cotés de la cavité lors du passage du courant. Cette élévation locale de température va induire une dilatation de l'élément **12** qui va ouvrir d'avantage la cavité **24,** ce qui facilite l'insertion de l'élément chauffant fusible **26** et de la bille **16** dans la cavité **24** une fois le courant appliqué.

Les éléments résistifs fusibles **26** prennent avantageusement la forme d'un serpentin. Un serpentin présente en effet une grande résistance électrique en raison de sa longueur élevée et de sa largeur faible, et donc un échauffement par effet Joule élevé, et ne recouvre pas totalement la résine **50** en laissant apparaître partiellement celle-ci, ce qui permet le retrait ultérieure de la résine. D'autres formes sont évidement possibles pour les éléments fusible **26,** comme par exemple des tiges ou des bandes parallèles connectées entre les plages **42, 44.** De préférence, le matériau et les caractéristiques géométriques des éléments chauffants sont choisis de manière à ce que ceux-ci fondent lorsqu'ils sont traversés par un courant électrique de quelques milliampères en fonction de la nature de l'élément chauffant fusible.

sible.

On montre que l'échauffement $\Delta T$ par seconde d'un élément **26** traversé par un courant d'intensité $I$ est modélisable au premier degré selon la relation :

$$\Delta T = \frac{\rho \times l^2}{2 \times k_p \times w^2 \times h^2} \times I^2$$

où :

- $\rho$ est la résistivité par mètre du matériau constitutif de l'élément **26,** en $\Omega/m$ ;
- $l$ est la longueur en mètre de l'élément **26** ;
- $w$ est la largeur en mètre de l'élément **26** ;
- $h$ est la hauteur en mètre de l'élément **26** ;
- $k_p$ est la conductivité thermique du matériau constitutif de l'élément **26,** en $W/K.m$ ; et
- $I$ est l'intensité en ampère du courant traversant l'élément **26.**

On dispose donc de plusieurs paramètres, à savoir les dimensions de l'élément **26,** la nature du ou des matériaux le constituant, ainsi que la valeur du courant le traversant, pour contrôler l'échauffement par effet Joule des éléments **26.** Notamment, il est possible de choisir des éléments **26** qui fondent très rapidement sous l'effet d'un courant de quelques milliampères à quelques dizaines de milliampères.

L'épaisseur des éléments résistifs fusibles **26** est également choisie entre 5 micromètres et 15 micromètres de manière à obtenir une quantité suffisante de matériau en fusion dans les cavités **24** pour fixer les billes **16.** Les éléments **26** sont avantageusement constitués d'un métal présentant une bonne mouillabilité et adhérence une fois fondu et refroidi avec le métal **32** déposé au fond des cavités **24,** par exemple de l'indium ou un alliage d'or et d'étain. Avantageusement, les éléments **26** sont réalisés en indium, ce métal présentant une bonne adhérence avec les métaux ainsi qu'un point de fusion bas égal à 152°C.

Le procédé se poursuit par le retrait de la résine **50** remplissant les cavités **26,** par exemple par voie humide ou au moyen d'un plasma, ce qui permet de ne pas détériorer le substrat **20** (figure en coupe 10A et figure de dessus 10B).

La figure 11 est une vue de dessus d'un second composant **12** illustrant un exemple de connexion électrique pour l'alimentation d'une matrice de N lignes d'éléments résistifs **26,** par exemple trois lignes, et de M colonnes d'éléments résistifs, par exemple trois colonnes. Pour des raisons de clarté, les plages de connexion **46, 48** ne sont pas représentées.

La connexion électrique est avantageusement une connexion en parallèle des éléments résistifs fusibles **26.** Par exemple, la connexion comporte, pour chaque colonne de la matrice, une première piste métallique **60,** formée sur la face **22** du composant **12,** et reliant chacune des plages de connexion **42** des éléments **26** de la colonne à une première piste métallique commune **62** formée sur la face **22.** De même, la connexion comporte pour chaque colonne de la matrice, une deuxième piste métallique **64,** formée sur la face **22** du composant **12,** et reliant chacune des plages de connexion **44** des éléments **26** de la colonne à une deuxième piste métallique commune **66** formée sur la face **22.** Les pistes communes **64, 66** sont chacune connectées à une borne d'alimentation électrique **30,** de sorte que l'application entre ces bornes d'une tension V permet de faire circuler un courant électrique sensiblement identique dans chacun des éléments **26.** Bien entendu, d'autres schémas de connexion sont possibles.

Une connexion en série est également réalisable dans le cas où les billes **16** sont alignées et posées au-dessus de l'élément chauffant fusible **26.** Ensuite, un courant est appliqué à l'ensemble en série est le chauffage est donc en même temps pour toutes les billes.

On note également que le volume de l'élément chauffant fusible peut être adaptable au volume des billes **16.** Par exemple si les billes **16** n'ont pas toutes le même volume, il est possible de tenir compte du volume variable en augmentant ou en diminuant le volume du matériau de l'élément chauffant fusible **26** afin d'assurer une bonne uniformité des connexions après le refroidissement du matériau.

## Revendications

**1.** Procédé de réalisation d'un dispositif hybridé consistant à réaliser un premier composant microélectronique (10) muni sur une face (14) de billes métalliques (16), et un second composant microélectronique (12) muni sur une face (22) d'éléments de connexion (26) correspondant auxdites billes métalliques (16), et à hybrider les premier et second composants (10, 12) de manière à fixer les billes métalliques (16) du premier composant (10) aux éléments de connexion (26) du second composant (12), dans lequel l'hybridation des premier et second composants (10, 12) consiste :

    o à reporter le premier composant (10) sur le second composant (12) de manière à faire reposer les billes métalliques (16) sur les éléments résistifs suspendus (26); et
    o à faire circuler un courant électrique au travers des éléments résistifs (26) de manière à faire fondre ceux-ci, *caractérisé*
**en ce que** la fabrication du second composant microélectronique (12) consiste :

        o à réaliser un substrat (20) muni de cavités (24) aux emplacements prévus pour les éléments de connexion (26); et

        o à réaliser des éléments résistifs en métal fusible (26) suspendus respectivement au dessus des cavités (24).

**2.** Procédé de réalisation d'un dispositif hybridé selon la revendication 1, *caractérisé* **en ce que** les éléments résistifs (26) sont réalisés sous la forme de serpentins ou de tiges.

**3.** Procédé de réalisation d'un dispositif hybridé selon la revendication 1 ou 2, *caractérisé* **en ce que** les éléments résistifs (26) sont constitués de métal à bas point de fusion, notamment en indium ou en alliage d'or et d'étain.

**4.** Procédé de réalisation d'un dispositif hybridé selon l'une quelconque des revendications précédentes, *caractérisé* **en ce que** le substrat (20) du second composant microélectronique (12) comprend du plastique, notamment du PEN ou du PET.

**5.** Procédé de réalisation d'un dispositif hybridé selon l'une quelconque des revendications précédentes, *caractérisé* **en ce que** la réalisation des éléments résistifs suspendus (26) consiste :

    ▪ à déposer deux plages métalliques (42, 44) autour de chaque cavité (24);
    ▪ à remplir les cavités (24) par de la résine (50);
    ▪ à réaliser des éléments résistifs (26) sur la résine (50) et sur les plages métalliques (42, 44), en laissant au moins un passage d'accès à la résine ; et
    ▪ à retirer la résine (50) des cavités (24) par le au moins un passage d'accès.

**6.** Procédé de réalisation d'un dispositif hybridé selon la revendication 5, *caractérisé* **en ce que** les plages métalliques de connexion (42) et (44) ont une surface supérieure ou égale à deux fois la surface de la cavité (24).

**7.** Procédé réalisation d'un dispositif hybridé selon l'une quelconque des revendications précédentes, *caractérisé* **en ce qu'**il consiste, avant la réalisation des éléments résistifs suspendus (26), à déposer une couche de métal (32) dans le fond de chaque cavité (24), et d'au moins une connexion électrique (46, 48) au contact de ladite couche (32).

**8.** Procédé de réalisation d'un dispositif hybridé selon l'une quelconque des revendications précédentes, *caractérisé* **en ce que** la hauteur des cavités (24) est supérieure ou égale à 1/8 de la hauteur des billes (16).

**Patentansprüche**

1. Verfahren zur Herstellung einer hybridisierten Vorrichtung, das darin besteht, ein erstes mikroelektronisches Bauelement (10), das auf einer Seite (14) mit Metallkugeln (16) versehen ist, und ein zweites mikroelektronisches Bauelement (12) herzustellen, das auf einer Seite (22) mit Verbindungselementen (26) versehen ist, die den Metallkugeln (16) entsprechen, und das erste und zweite Bauelement (10, 12) so zu hybridisieren, dass die Metallkugeln (16) des ersten Bauelements (10) an den Verbindungselementen (26) des zweiten Bauelements (12) befestigt werden, **dadurch gekennzeichnet:**

   - **dass** die Fertigung des zweiten mikroelektronischen Bauelements (12) darin besteht:

      ○ ein Substrat (20) herzustellen, das mit Hohlräumen (24) an den Stellen versehen ist, die für die Verbindungselemente (26) vorgesehen sind; und
      ○ Widerstandselemente (26) aus schmelzbarem Metall herzustellen, die jeweils über den Hohlräumen (24) aufgehängt sind;

   - und **dass** die Hybridisierung des ersten und zweiten Bauelements (10, 12) darin besteht:

      ○ das erste Bauelement (10) auf dem zweiten Bauelement (12) so zu verschieben, dass die Metallkugeln (16) auf den aufgehängten Widerstandselementen (26) zu liegen kommen; und
      ○ einen elektrischen Strom durch die Widerstandselemente (26) fließen zu lassen, so dass diese schmelzen.

2. Verfahren zur Herstellung einer hybridisierten Vorrichtung nach Anspruch 1, **dadurch gekennzeichnet, dass** die Widerstandselemente (26) in Form von Schlangen oder Stäben hergestellt werden.

3. Verfahren zur Herstellung einer hybridisierten Vorrichtung nach Anspruch 1 oder 2, **dadurch gekennzeichnet, dass** die Widerstandselemente (26) aus einem Metall mit niedrigem Schmelzpunkt, insbesondere aus Indium oder einer Gold- und Zinnlegierung gebildet werden.

4. Verfahren zur Herstellung einer hybridisierten Vorrichtung nach einem der vorhergehenden Ansprüche, **dadurch gekennzeichnet, dass** das Substrat (20) des zweiten mikroelektronischen Bauelements (12) Kunststoff, insbesondere PEN oder PET umfasst.

5. Verfahren zur Herstellung einer hybridisierten Vorrichtung nach einem der vorhergehenden Ansprüche, **dadurch gekennzeichnet, dass** die Herstellung der aufgehängten Widerstandselemente (26) darin besteht:

   ■ zwei Metallbereiche (42, 44) um jeden Hohlraum (24) abzuscheiden;
   ■ die Hohlräume (24) mit Harz (50) zu füllen;
   ■ Widerstandselemente (26) auf dem Harz (50) und den Metallbereichen (42, 44) herzustellen, wobei mindestens ein Zugangsdurchgang zum Harz belassen wird; und
   ■ das Harz (50) durch den mindestens einen Zugangsdurchgang aus den Hohlräumen (24) zu entfernen.

6. Verfahren zur Herstellung einer hybridisierten Vorrichtung nach Anspruch 5, **dadurch gekennzeichnet, dass** die Metallverbindungsbereiche (42) und (44) eine Fläche haben, die größer als das oder gleich dem Zweifache/n der Fläche des Hohlraums (24) ist.

7. Verfahren zur Herstellung einer hybridisierten Vorrichtung nach einem der vorhergehenden Ansprüche, **dadurch gekennzeichnet, dass** es darin besteht, vor der Herstellung der aufgehängten Widerstandselemente (26) eine Metallschicht (32) auf dem Grund jedes Hohlraums (24) und mindestens einer elektrischen Verbindung (46, 48) abzuscheiden, die mit der Schicht (32) in Kontakt steht.

8. Verfahren zur Herstellung einer hybridisierten Vorrichtung nach einem der vorhergehenden Ansprüche, **dadurch gekennzeichnet, dass** die Höhe der Hohlräume (24) größer als oder gleich 1/8 der Höhe der Kugeln (16) ist.

**Claims**

1. A method of forming a hybridized device comprising forming a first microelectronic component (10) provided, on a surface (14), with metal balls (16), and a second microelectronic component (12) provided, on a surface (22), with connection elements (26) corresponding to said metal balls (16), and hybridizing the first and second components (10, 12) to attach the metal balls (16) of the first component (10) to the connection elements (26) of the second component (12), and wherein the hybridization of the first and second components (10, 12) comprises:

   ○ transferring the first component (10) onto the second component (12) to have the metal balls (16) rest on the suspended resistive elements (26); and
   ○ circulating an electric current through the resistive elements (26) to melt said elements. **characterized in that** the manufacturing of the second microelectronic component (12) comprises:

  ∘ forming a substrate (20) provided with cavities (24) at the locations provided for the connection elements (26); and
  ∘ forming resistive elements made of fusible metal (26) respectively suspended above the cavities (24).

2. The method of forming a hybridized device of claim 1, wherein the resistive elements (26) are made in the form of coils or of rods.

3. The method of forming a hybridized device of claim 1 or 2, wherein the resistive elements (26) are made of a metal of low melting point, for example, indium or a gold and tin alloy.

4. The method of forming a hybridized device of any of the foregoing claims, wherein the substrate (20) of the second microelectronic component (12) comprises plastic, particularly PEN or PET.

5. The method of forming a hybridized device of any of the foregoing claims, wherein the forming of the suspended resistive elements (26) comprises:

  ▪ depositing two metal areas (42, 44) around each cavity (24);
  ▪ filling the cavities (24) with resin (50);
  ▪ forming the resistive elements (26) on the resin (50) and on the metal areas (42, 44), while leaving at least one passage of access to the resin; and
  ▪ removing the resin (50) from the cavities (24) through the at least one access passage.

6. The method of forming a hybridized device of claim 5, wherein the metal connection areas (42) and (44) have a surface area greater than or equal to twice the surface area of the cavity (24).

7. The method of forming a hybridized device of any of the foregoing claims, wherein it comprises, before the forming of the suspended resistive elements (26), depositing a metal layer (32) at the bottom of each cavity (24), and at least one electric connection (46, 48) in contact with said layer (32).

8. The method of forming a hybridized device of any of the foregoing claims, wherein the height of the cavities (24) is greater than or equal to 1/8 of the height of the balls (16).

**Fig. 1**

**Fig. 2**

**Fig. 3**

Fig. 4 ──── 20

Fig. 5

22    24    20

Fig. 6

24    40    20

22    42    44    20

Fig. 7A    32

42    46    44

20

Fig. 7B    48    32    20

$e_g$

42    50    44    20

Fig. 8A    32

42    46    44

20

Fig. 8B    48    50

**Fig. 9A**

**Fig. 9B**

**Fig. 10A**

**Fig. 10B**

**Fig. 11**

**EP 2 766 927 B1**

## RÉFÉRENCES CITÉES DANS LA DESCRIPTION

**Documents brevets cités dans la description**

- US 5700987 A